# NOUVEAU FASCICULE DE BREVET EUROPEEN

(11) **EP 0 344 058 B2**
(45) Date de publication et mention de la décision concernant l'opposition: **13.08.1997**
(45) Mention de la délivrance du brevet: 03.11.1993
(21) Numéro de dépôt: 89401407.5
(22) Date de dépôt: 24.05.1989
(51) Int. Cl.: G06K 19/06

(54) **Procédé de réalisation d'une carte à mémoire électronique et carte à mémoire électronique obtenue par la mise en oeuvre dudit procédé**
Herstellungsverfahren einer elektronischen Speicherkarte und elektronische Speicherkarte, die nach diesem Verfahren hergestellt ist
Process for producing an electronic memory card, and electronic memory card obtained by using this process

(30) Priorité: 25.05.1988 FR 8806921
(43) Date de publication de la demande: 29.11.1989
(73) Titulaire: SCHLUMBERGER INDUSTRIES, F-92120 Montrouge (FR)
(72) Inventeur: Rose, René, F-78190 Voisin le Bretonneux (FR)
(74) Mandataire: Hasenrader, Hubert

(56) Documents cités:
- EP-A- 0 197 438
- EP-A- 0 207 853
- EP-A- 0 254 640
- DE-A- 3 338 597
- FR-A- 2 584 862

## Description

La présente invention a pour objet un procédé de réalisation d'une carte à mémoire électronique et une carte électronique obtenue par la mise en oeuvre dudit procédé.

Comme cela est bien connu une carte à mémoire électronique comprend essentiellement un corps de carte réalisé en général en un matériau plastique dans lequel est fixé un module électronique. Le plus souvent le module électronique comprend un élément de circuit imprimé . Sur la face externe du circuit imprimé sont réalisées des métallisations qui définissent les plages externes de contact électrique de la carte. Sur la face interne du circuit imprimé est fixée une pastille semi-conductrice dont les bornes sont reliées électriquement aux plages de contact par différentes techniques. Les plages externes servent à réaliser une liaison électrique entre le circuit de la carte et un lecteur de cartes.

Cependant le circuit imprimé est relativement onéreux d'une part parce qu'il comporte un support isolant dont le prix n'est pas négligeable et d'autre part, et surtout, par ce que la définition géométrique des différentes métallisations réalisées sur le support isolant est obtenue par gravure chimique d'une couche de métallisation déposée de façon uniforme sur le support isolant. Or la gravure chimique est une opération onéreuse.

Pour diminuer le prix du module électronique on a déjà proposé dans la demande de brevet européen 254.640 de remplacer le circuit imprimé par un cadre conducteur (en anglais lead-frame). En d'autres termes le module électronique est constitué par un ensemble de conducteurs électriques sensiblement plans sur lequel est directement fixée la pastille semi-conductrice. Les différents conducteurs électriques sont obtenus par découpage ou poinçonnage d'une bande métallique continue, ce qui évite ainsi l'opération de gravure chimique.

La demande de brevet européen EP-A-0 197 438 décrit un procédé tel que décrit dans le paragraphe précédent à la différence près qu'une pastille isolante est fixée entre le cadre conducteur et la pastille semi-conductrice.

FR-A-2 584 862 décrit un procédé de réalisation d'une pluralité de modules électroniques qui comprend l'étape de dépôt d'une couche isolante de protection sur le cadre conducteur.

La présente invention a pour objet un nouveau procédé de réalisation de carte, et plus particulièrement de réalisation du module électronique, qui utilise également un cadre conducteur, et qui facilite la mise en place du module électronique dans le corps de carte.

Pour atteindre ce but le procédé de l'invention est défini à la revendication 1.

On comprend que grâce à l'adjonction du matériau isolant la résistance mécanique du cadre conducteur est considéralement augmentée ce qui permet de le séparer aisément du reste de la bande conductrice. Cependant cette technique ne présente pas le surcoût entrainé par l'utilisation d'un circuit classique.

D'autres caractéristiques et avantages de l'invention apparaitront plus clairement à la lecture de la description qui suit de plusieurs modes de réalisation de l'invention donnés à titre d'exemples non limitatifs. La description se réfère au dessin annexé sur lequel :
La figure 1 est une vue de dessus d'une bande métallique usinée pour former plusieurs cadres conducteurs ;
La figure 2 montre la bande métallique de la figure 1 munie du matériau isolant de renforcement ;
La figure 3 montre en vue de dessous la bande métallique de la figure 2 sur laquelle on a fixé une pastille semi conductrice ;
La figure 4 est une vue de dessus d'un module électronique complet après sa séparation du reste de la bande métallique ;
La figure 5 est une vue en coupe verticale montrant un premier mode de fixation du module électronique sur le corps de carte ;
La figure 6 montre une variante de mise en place sur la bande métallique de l'élément isolant de renforcement ; et
La figure 7 montre une variante du mode de fixation de la pastille semiconductrice sur le cadre conducteur.

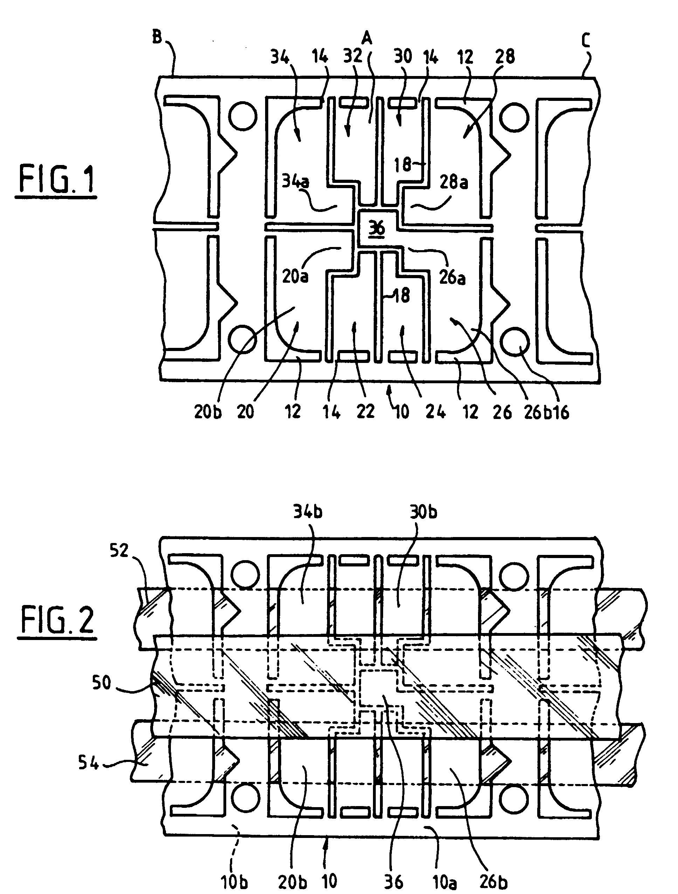

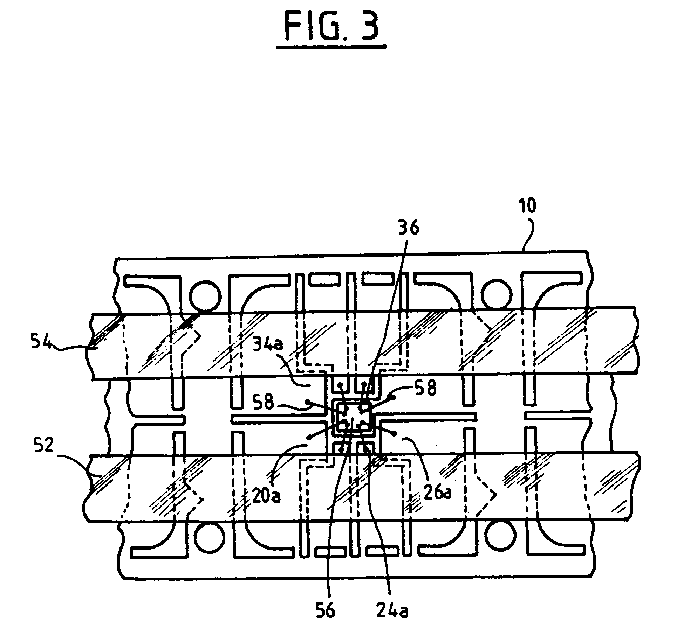

En se référant tout d'abord aux figures 1 à 5, on va décrire un premier mode de réalisation d'une carte à mémoire selon l'invention.

La figure 1 montre, en vue de dessus, une portion de bande métallique conductrice 10 dans laquelle ont été réalisées des usinages pour définir une succession de motifs identiques. Sur la figure 1 on voit le motif A et, partiellement les motifs B et C. La bande 10 a, par exemple, une épaisseur de 0,1 mm et une largeur de 16 mm. Elle est réalisée en cuivre recouvert sur ses deux faces d'un dépôt de nickel de 3 micromètres d'épaisseur. Plus généralement l'épaisseur de la bande conductrice est comprise entre 0,075 mm et 0,25 mm.. Chaque motif, que l'on appellera ultérieurement cadre conducteur, est séparé du reste de la bande 10 par une fente 12. Le cadre conducteur A ainsi séparé du reste de la bande 10 a une forme générale rectangulaire de 12,8 mm sur 11,6 mm. Comme le montre la figure 1, la fente 12 n'est pas continue. Elle est interrompue par des "ponts" 14 qui relient mécaniquement le cadre conducteur A au reste de la bande. De plus la bande 10 comporte des trous de repérage 16.

Le cadre conducteur A est séparé par des fentes 18 en plusieurs zones conductrices. Sur la figure 1 on a représenté les zones conductrices 20 à 34. Chaque zone conductrice 20 à 34, comporte une zone de connexion 20a à 34a proche du centre du cadre conducteur, et une zone de contact 20b à 34b, qui est proche de la périphérie du cadre conducteur. Les zones de connexion 20a à 34a ont une surface réduite par rapport aux zones de contact 20b à 34b.

La figure 1 montre que la zone de connexion 34a est prolongée par une zone centrale 36. Les fentes 18 qui séparent les zones conductrices sont reliées entre elles dans la région qui définit la zone centrale 36. L'autre extrémité de chaque fente 18 s'interrompt dans l'un des ponts 14 qui relient le cadre conducteur A au reste de la bande 10. Les différents usinages décrits précédemment, fentes 12 et 18, trous 16 peuvent avantageusement être réalisés par poinçonnage, ce qui constitue une opération peu onéreuse.

Dans l'étape suivante, illustrée par la figure 2, on fixe sur la face supérieure ou externe 10a de la bande métallique 10, une bande 50 en matériau isolant : La bande 50 a une largeur nettement inférieure à celle de la bande métallique 10 de telle manière qu'elle recouvre la zone centrale 36, et les zones de connexion 20a à 34a mais qu'elle laisse dégagées les zones de contact 20b à 34b. La bande isolante 50 a par exemple une largeur de 4,8 mm et une épaisseur de 0,07 mm. Elle est par exemple réalisée avec le matériau commercialisé sous la marque Kapton. Une face de la bande 50 est enduite d'un matériau adhésif. Il s'agit par exemple du matériau commercialisé par la Société Dupont de Nemours sous la marque PYRALUX. On fixe également sur la face inférieure ou interne 10b de la bande métallique 10 deux bandes isolantes 52 et 54 disposées selon la même direction que la bande 50 et de même nature que celle-ci. Comme le montre la figure 2, les bandes 52 et 54 laissent dégagées les zones de connexions 20a et 34a et recouvrent la plus grande partie des zones de contact 20b à 34b. De plus on a prévu un certain recouvrement entre la bande 50 et les bandes 52 et 54. On obtient ainsi une bande métallique renforcée par les bandes isolantes 50, 52 et 54.

Pour chaque cadre conducteur, les zones de contact 20b et 34b de la face supérieure 10a sont dégagées alors que les zones de connexions 20a à 34a de la face inférieure 10b sont également dégagées.

Dans l'étape suivante on réalise, de préférence, un dépôt d'or sur les deux faces 10a et 10b de la bande 10 dans les régions non recouvertes par les bandes 50 à 54. On comprend qu'on réalise ainsi une économie substantielle par rapport à la technique connue qui consiste à réaliser le dépôt d'or sur toute la bande 10.

L'étape suivante consiste à fixer sur la face inférieure 10b de chaque cadre conducteur A une pastille semi-conductrice 56. La pastille 56 est fixée sur la zone centrale 36 du cadre conducteur. Selon les pastilles semi-conductrices utilisées elles sont fixées sur le cadre conducteur à l'aide d'un matériau adhésif isolant ou conducteur. Puis on relie par des fils conducteurs 58 chaque borne de la pastille 56 à une zone de connexion 20a à 34a de la face inférieure 10b du cadre conducteur. Cette opération est possible puisque les zones de connexion ne sont pas recouvertes par les bandes 52 et 54 et qu'elles ont été préalablement dorées.

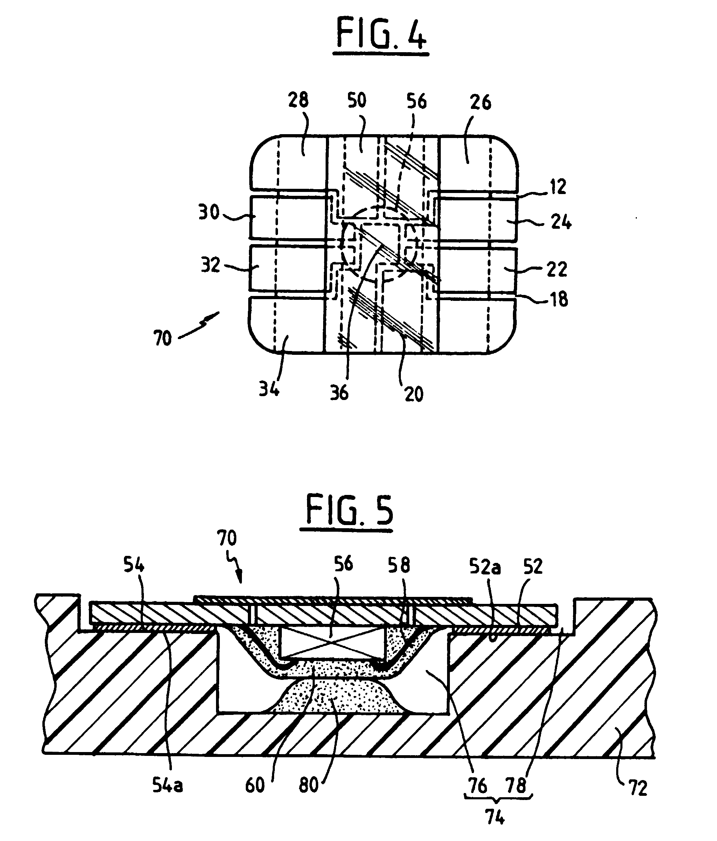

Dans l'étape suivante on dépose sur la face inférieure 10b du cadre conducteur une goutte de matériau isolant adhésif 60 pour que ce matériau enrobe la pastille 56 et les fils conducteurs 58 comme cela est visible sur la figure 5. On obtient ainsi un module électronique complet constitué par un cadre conducteur A et une pastille semi-conductrice 56, le module électronique étant encore relié mécaniquement au reste de la bande 10 par les ponts métalliques 14 et par les bandes isolantes 50, 52 et 54. Cette bande peut donc être manipulée aisément.

Dans l'étape suivante on sépare les modules électroniques de la bande 10 en découpant avec un outil convenable les ponts 14 et les bandes 50, 52 et 54 au droit des fentes 12.

On obtient alors des modules électroniques 70 tels que celui qui est représenté sur la figure 4. Il comprend le cadre conducteur qui est constitué par les huit zones conductrices 20 à 34 qui sont électriquement séparées les unes des autres par les fentes 18. La face supérieure du module électronique 70 montre la portion découpée de bande isolante 50 et, de part et d'autre de celle-ci, les zones de contact dorées 20b 34b. Sur la face inférieure du module électronique on voit, dans la région centrale, le matériau isolant 60 dans lequel est noyée la pastille semi-conductrice 56 et les portions de bandes isolantes 52 et 54.

Dans la dernière étape on fixé le module électronique 70 sur le corps de la carte. La figure 5 montre une partie d'un corps de carte 72 muni d'une cavité 74 pour la mise en place du module électronique 70. La cavité 74 est étagée. Elle comprend un logement inférieur 76 pour recevoir la pastille enrobée 60 et un logement supérieur 78 pour recevoir la cadre conducteur. Dans le mode de fixation illustré par la figure 5, les bandes isolantes 52 et 54 sont revêtues sur leur face 52a, 54a non fixée sur le cadre conducteur d'un matériau adhésif bistable. Par apport d'énergie thermique localisé le matériau adhésif est activé pour adhérer au fond du logement supérieur 78. On obtient ainsi une très bonne solidarisation entre le module électronique 70 et le corps de carte 72.

Pour améliorer encore la fixation du module électronique sur le corps de carte on peut déposer, avant la mise en place du module électronique, une goutte 80 de matériau adhésif sur le fond du logement 76. Lors de la mise en place du module électronique, la goutte 80 entre en contact avec le matériau 60 d'enrobage de la pastille semi-conductrice. Après polymérisation de la goutte 80 le module électronique 70 est fixé au corps de carte 72 non seulement par les bandes adhésives 52 et 54 mais également par la goutte 80.

Bien entendu d'autre techniques de fixation du module électronique sur le corps de carte peuvent être mise en oeuvre. Par exemple on peut utiliser celles qui sont décrites dans la demande de brevet européen 254.640 déjà mentionnée.

Il découle de la description précédente que le procédé de réalisation d'un module électronique selon la présente invention présente de nombreux avantages par rapport aux techniques de l'art antérieur. Il évite l'utilisation dû circuit imprimé qui est onéreux. Grâce au renforcement du cadre conducteur par la ou les bandes isolantes le découpage du module électronique à partir de la bande métallique peut se faire aisément malgré les faibles dimensions des zones conductrices du cadre conducteur. Lors de la réalisation du dépôt d'or sur la bande métallique, les bandes isolantes servent de masques pour limiter la zone de dépôt aux portions des deux faces de la bande métallique où il est nécessaire d'avoir un bon contact ohmique, c'est à dire les zones de connexion des fils conducteurs 58 et les zones de contact externe. En outre, comme il y a un léger recouvrement entre la bande isolante 50 et les bandes isolantes 52 et 54, le matériau d'enrobage 60 de la pastille semi-conductrice ne risque pas de déborder sur la face supérieure du cadre conducteur en passant par les fentes 18.

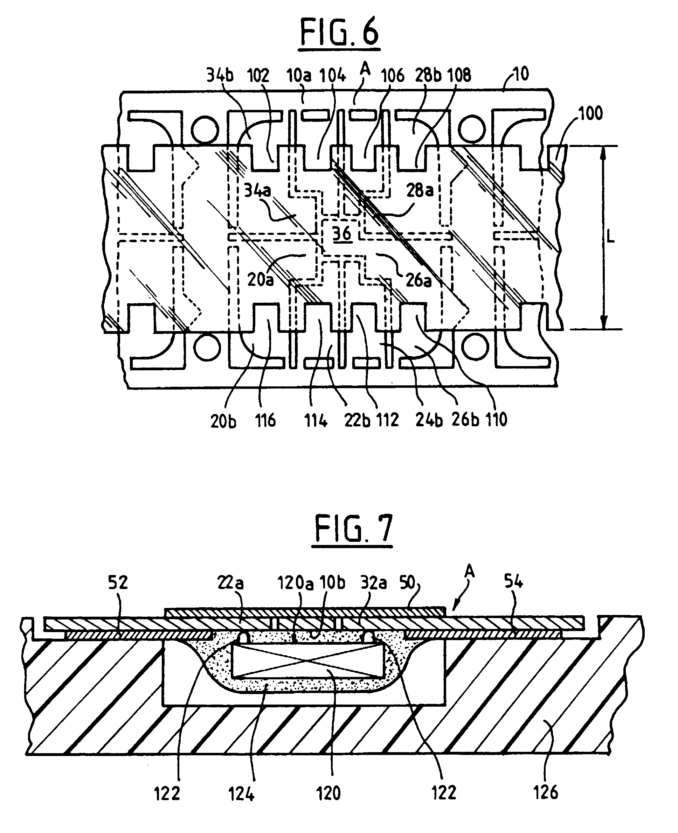

La figure 6 illustre une variante du procédé de fabrication du module électronique. On part d'une bande métallique 10 identique à celle de la figure 1. On ne la décrira donc pas à nouveau, et on a reporté sur la figure 6 les références de la figure 1. On fixe sur la face supérieure 10a de la bande métallique une bande isolante 100. La bande 100 a une largeur L supérieure à celle de la bande 50. En d'autres termes la bande 100 recouvre non seulement les zones de connexion 20a à 34a mais également la plus grande partie des zones de contact 20b à 34b. La bande 100 est en un matériau isolant photo polymerisable par masquage et insolation de la bande 100. Il s'agit par exemple du matériau commercialisé sous la marque VACREL par la Société Dupont de Nemours. Lorsque la bande isolante 100 est fixée sur la bande métallique 10, on définit des ouvertures 102 à 116 correspondant aux zones de contact 20b à 34b . Les ouvertures 102 à 116 ont des dimensions correspondant aux normes ISO ou AFNOR. L'avantage de cette solution réside dans le fait que la bande 100 ayant une plus grande largeur le renforcement mécanique obtenu est plus important.

En outre, lors de la réalisatiqn du dépôt d'or la surface libre est sensiblement égale à la surface utile de contact électrique. Cela permet de réduire encore le poids d'or nécessaire.

La figure 7 montre une variante de réalisatior du module électronique et plus précisément une variante du mode de fixation de la pastille semi conductrice sur le cadre conducteur. Selon cette variante on part d'un cadre conducteur, de préférence en bande, obtenu par le procédé décrit en liaison avec les figures 1 et 2 ou par le procédé décrit en liaison avec la figure 6. La figure 7 correspond au procédé des figures 1 et 2.

Le cadre conducteur A est muni des portions de bandes isolantes 50, 52 et 54. Les bandes 52 et 54 laissent dégagées les zones de connexion 20a à 34a. (seules les zones 22a et 32a apparaissent sur la figure 7) de la face inférieure 10b du cadre conducteur. La pastille semi-conductrice 120 est soumise à une préparation spécifique. Les bornes de sortie de la pastille 120 sont réhaussées par des plots métalliques tels que 122 qui font saillie hors de la face 120a de la pastille 120. Les plats 122 sont directement soudés sur les zones de connexion 20a à 34a. Ce mode de connexion d'un circuit semi-conducteur à des pistes conductrices est généralement désigné par le terme anglo-saxon "bumping". Cette technique présente l'avantage d'éviter l'utilisation de fils conducteurs qui peuvent consitituer un point faible du module électronique.

La pastille 120 est ensuite enrobée dans un matériau isolant 124. Le module électronique ainsi obtenu est séparé du reste de la bande métallique et fixé sur le corps de carte 126 par une des techniques déjà décrites.

## Revendications

1. Procédé de réalisation d'une pluralité de cartes à mémoire électronique comprenant chacune un module électronique (70) monté sur un corps de carte (72) comprenant les étapes suivantes :
a) On fournit une bande (10) en matériau conducteur dans laquelle est réalisée une pluralité de cadres conducteurs (A, B, C), chaque cadre conducteur comportant une pluralité d'éléments conducteurs (20 à 34) séparés les uns des autres mais reliés mécaniquement au reste de ladite bande, au moins une partie de chaque élément conducteur formant une plage externe (20b à 34b) de contact électrique ;
b) on fixe sur ladite bande conductrice un matériau isolant (50, 52, 54) de renforcement de telle manière que ledit matériau de renforcement recouvre une partie de chaque élément conducteur de chaque cadre conducteur mais ne recouvre ni lesdites plages de contact externe desdits cadres conducteurs disposées sur une face externe (10a) de ladite bande conductrice, ni des zones de connexion (20a à 34a) de chaque élément conducteur disposées sur la face interne (10b) de ladite bande;
c) On fixe sur la face interne de chaque cadre conducteur une pastille semi-conductrice (56) et on relie les bornes de ladite pastille aux zones de connexion dudit cadre ;
d) On sépare chaque cadre conducteur du reste de la bande par quoi on obtient des modules électroniques (70); et
e) On fixe chaque module électronique ainsi obtenu sur un corps de carte (72); et à l'étape b), pour fixer ledit matériau isolant de renforcement, on fixe sur la face externe de la bande conductrice une première bande (50) du matériau isolant de renforcement pour laisser dégager de part et d'autre de ladite bande isolante lesdites plages externes de contact électrique, et on fixe sur la face interne de la bande conductrice une deuxième et une troisième bandes (52, 54) du matériau isolant de renforcement pour laisser entre lesdites deuxième et troisième bandes isolantes lesdites zones de connexion et des zones de fixation des pastilles semi-conductrices non recouvertes par ledit matériau isolant.

2. Procédé selon la revendication 1, caractérisé en ce que après la fixation dudit matériau isolant, on réalise un dépôt d'or sur les faces interne et externe desdits cadres conducteurs dans leurs parties non recouvertes par ledit matériau isolant.

3. Procédé selon la revendication 1, caractérisé en ce qu'il y a un recouvrement entre la première bande isolante et chacune desdites deuxième et troisième bandes isolantes.

4. Procédé selon l'une quelconque des revendications 1 à 3 caractérisé en ce que, pour fixer ledit matériau isolant on utilise un matériau isolant comportant sur une de ses faces un matériau adhésif.

5. Procédé selon la revendication 1 caractérisé en ce que lesdites deuxième et troisième bandes isolantes sont adhésives sur leurs deux faces et en ce que lesdites bandes sont fixées par une de leur face sur ledit cadre conducteur et en ce que ledit module électronique est fixé sur ledit corps de carte par la deuxième face adhésive desdites deuxième et troisième bandes isolantes.

6. Procédé selon l'une quelconque des revendications 1 à 5, caractérisé en ce que le ou lesdits cadres conducteurs ont une épaisseur de 0,1 mm.

7. Procédé selon l'une quelconque des revendications 1 à 6, caractérisé en ce que lesdites bandes de matériau isolant ont une épaisseur de 0,07 mm.

8. Procédé selon l'une quelconque des revendications 1 à 7, caractérisé en ce que lesdites bandes en matériau isolant ont une largeur inférieure à celle du ou des cadres conducteurs.

## Claims

1. Method of making a plurality of electronic memory cards each comprising an electronic module (70) mounted on a card body (72) and comprising the following steps:
a) a strip (10) of conducting material is provided and a plurality of lead-frames (A, B, C) is formed therein, each lead-frame comprising a plurality of conductor elements (20 to 34) separated from one another but mechanically connected to the remainder of said strip, at least one portion of each conductor element constituting an external electrical contact tab (20b to 34b);
b) an insulating reinforcement material (50, 52, 54) is fixed on said conducting strip in such a manner that said reinforcement material covers a portion of each conductor element in each lead-frame, but covers neither said external contact tabs of said lead-frames disposed on an outside face (10a) of said conducting strip, nor the connection zones (20a to 34a) of each conductor element disposed on the inside face (10b) of said strip;
c) a semiconductor chip (56) is fixed on the inside face of each lead-frame and the terminals of said chip are fixed to the connection zones of said frame;
d) each lead-frame is separated from the remainder of the strip, thereby obtaining electronic modules (70);
e) each electronic module obtained in this way is fixed on a card body (72);
and at step b) in order to fix said insulating reinforcement material, a first strip (50) of insulating reinforcement material is fixed on the outside face of the conducting strip so as to leave said external electrical contact tabs uncovered on either side of said insulating strip, and second and third strips (52, 54) of insulating reinforcement material are fixed on the inside face of the conducting strip so as to leave said connection zones and semiconductor chip fixing zones uncovered by said insulating material between said second and third strips.

2. Method according to claim 1, characterised in that after said insulating material has been fixed on said lead-frames, gold is deposited on the inside and outside faces thereof in those portions which are not covered by said insulating material.

3. Method according to claim 1, characterised in that the first insulating strip overlaps each of said second and third insulating strips.

4. Method according to any one of claims 1 to 3, characterised in that one of the faces of said insulating material includes an adhesive material for the purpose of fixing said insulating material.

5. Method according to claim 1, characterised in that said second and third insulating strips are adhesive on both faces, and in that said strips are fixed via one of their faces to said lead-frame and in that said electronic module is fixed to said card body by the second adhesive face of said second and third insulating strips.

6. Method according to any one of claims 1 to 5, characterised in that said lead-frame or lead-frames are 0.1 mm thick.

7. Method according to any one of claims 1 to 6, characterised in that said strips of insulating material are 0.07 mm thick.

8. Method according to any one of claims 1 to 7, characterised in that said strips of insulating material are narrower than the lead-frame or lead-frames.

## Patentansprüche

1. Verfahren zur Herstellung von mehreren elektronischen Speicherkarten, die jeweils einen auf einem Kartenkörper (72) angebrachten elektronischen Modul aufweisen, mit den folgenden Schritten :
a) Bereitstellen eines Streifens (10) aus leitendem Material, in dem mehrere Leiterrahmen (A, B, C) verwirklicht sind, wobei jeder Leiterrahmen mehrere Leiterelemente (20 bis 34) aufweist, die voneinander getrennt sind, jedoch mit dem verbleibenden Streifen mechanisch verbunden sind, wobei wenigstens ein Teil eines jeden Leiterelementes einen äußeren Bereich (20b bis 34b) für den elektrischen Kontakt bildet;
b) Befestigen eines Verstärkungs- Isoliermaterials (50, 52, 54) auf dem leitenden Streifen, derart, daß das Verstärkungsmaterial einen Teil eines jeden Leiterelementes eines jeden Leiterrahmens abdeckt, jedoch weder die an einer Außenfläche (10a) des leitenden Streifens angeordneten Bereiche für den äußeren Kontakt der Leiterrahmen noch die an der Innenfläche (10b) des Streifens angeordneten Verbindungszonen (20a bis 34a) eines jeden Leiterelementes abdeckt ;
c) Befestigen eines Halbleiterchips (56) auf der Innenfläche eines jeden Leiterrahmens und Verbinden der Anschlüsse des Chips mit den Verbindungszonen des Rahmens;
d) Trennen eines jeden Leiterrahmens vom restlichen Streifen, wodurch elektronische Module (70) erhalten werden;
e) Befestigen eines jeden auf diese Weise erhaltenen elektronischen Moduls auf dem Kartenkörper (72);
wobei bei Schritt b) für die Befestigung des Verstärkungs-Isoliermaterials auf der Außenfläche des Leiterstreifens ein erster Streifen (50) aus dem Verstärkungs-Isoliermaterial befestigt wird, um die äußeren Bereiche des für den elektrischen Kontakt auf beiden Seiten des isolierenden Streifens abzukoppeln, und wobei auf der Innenfläche des Leiterstreifens ein zweiter und ein dritter Streifen (52, 54) des Verstärkungs- Isoliermaterials befestigt werden, um zwischen dem zweiten und dem dritten Isolierstreifen die Verbindungszonen und Zonen für die Befestigung der Halbleiterchips, die vom Isoliermaterial nicht abgedeckt sind, übrig zu lassen.

2. Verfahren gemäß Anspruch 1, dadurch gekennzeichnet daß nach der Befestigung des Isoliermaterials auf den Innen- und Außenflächen der Leiterrahmen auf ihren nicht vom Isoliermaterial abgedeckten Teilen ein Niederschlag von Gold verwirklicht wird.

3. Verfahren gemäß Anspruch 1, dadurch gekennzeichnet daß zwischen dem ersten Isolierstreifen und jedem der zweiten und dritten Isolierstreifen eine Überlappung vorhanden ist.

4. Verfahren gemäß einem der Anspniche 1 bis 3, dadurch gekennzeichnet daß für die Befestigung des Isoliermaterials ein Isoliermaterial verwendet wird, das auf einer seiner Flächen ein Klebstoffmaterial aufweist.

5. Verfahren gemäß Anspruch 1, dadurch gekennzeichnet daß die zweiten und dritten Isolierstreifen auf ihren beiden Flächen mit einem Klebstoff versehen sind und daß die Streifen mit einer ihrer Flächen am Leiterrahmen befestigt sind und daß der elektrische Modul am Kartenkörper durch die zweite klebende Fläche der zweiten und dritten Isolierstreifen befestigt ist.

6. Verfahren gemäß einem der Ansprüche 1 bis 5, dadurch gekennzeichnet daß der oder die Leiterrahmen eine Dicke von 0,1 mm besitzen.

7. Verfahren gemäß einem der Ansprüche 1 bis 6, dadurch gekennzeichnet daß die Streifen aus Isoliermaterial eine Dicke von 0,07 mm besitzen.

8. Verfahren gemäß einem der Ansprüche 1 bis 7, dadurch gekennzeichnet daß die Streifen aus Isoliermaterial eine Breite besitzen, die kleiner als diejenige des oder der Leiterrahmen ist.
